(19) Europäisches Patentamt

European Patent Office

Office européen des brevets

(11) **EP 1 186 896 B1**

(12) **EUROPÄISCHE PATENTSCHRIFT**

(45) Veröffentlichungstag und Bekanntmachung des Hinweises auf die Patenterteilung:
**18.01.2006 Patentblatt 2006/03**

(51) Int Cl.:
***G01R 15/24*** *(2006.01)*

(21) Anmeldenummer: **01119251.5**

(22) Anmeldetag: **09.08.2001**

(54) **Verfahren und Vorrichtung zur elektrooptischen Messung elektrischer Spannung**

Electro-optical method and apparatus for measuring an electrical voltage

Procédé et appareil de mesure électro-optique d'une tension électrique

(84) Benannte Vertragsstaaten:
**CH FR GB IT LI SE**

(30) Priorität: **07.09.2000 DE 10044197**

(43) Veröffentlichungstag der Anmeldung:
**13.03.2002 Patentblatt 2002/11**

(73) Patentinhaber: **LITEF GmbH**
**79115 Freiburg (DE)**

(72) Erfinder: **Handrich, Eberhard, Dr.**
**79199 Kirchzarten (DE)**

(74) Vertreter: **Müller - Hoffmann & Partner**
**Patentanwälte,**
**Innere Wiener Strasse 17**
**81667 München (DE)**

(56) Entgegenhaltungen:
| | |
|---|---|
| **WO-A-00/19217** | **DE-A- 4 128 687** |
| **DE-A- 19 808 517** | **GB-A- 2 243 680** |
| **US-A- 5 343 036** | |

**Beschreibung**

Die Erfindung betrifft ein Verfahren und eine Vorrichtung zur elektrooptischen Messung elektrischer Spannung.

Es ist grundsätzlich bekannt, elektrische Ströme oder Spannungen über dadurch erzeugte eletromagnetische Felder mittels elektrooptischer Messmethoden zu messen (vergleiche beispielshalber DE 198 08 517 A1). Ein Beispiel für ein mögliches Einsatzgebiet der elektrooptischen Spannungsmessung stellt der Kraftwerkbereich dar, wo Messgeräte von der zu messenden Hochspannung ferngehalten werden sollen.

Bekannte optische Spannungsmessgeräte basieren beispielsweise auf dem physikalischen Prinzip eines Mach-Zehnder-Interferometers. In einem solchen Interferometer wird ein Lichtstrahl in mindestens zwei Teilstrahlen aufgespalten, die, nachdem sie definierte Wege zurückgelegt haben, wieder zu einem Strahl vereinigt werden. Die Intensität des wiedervereinigten Gesamtlichtstrahls ist aufgrund von Interferenz abhängig von einer möglichen Phasendifferenz der beiden Teilstrahlen. Diese Phasendifferenz wird bei optischen Spannungsmessgeräten durch die zu messende Spannung erzeugt, die den Lichtweg der Teilstrahlen beeinflussende Elektroden so beaufschlagt, dass die Teilstrahlen nach Durchlaufen der definierten Wege eine Phasendifferenz gegeneinander aufweisen, deren Betrag der Stärke der an den Elektroden anliegenden, zu messenden Spannung entspricht.

Um diese Phasendifferenz zu messen, wird üblicherweise über ein zweites Paar von Elektroden mit Hilfe eines Rückstellsignals eine zusätzliche Phasendifferenz erzeugt, die so geregelt wird, daß sie die durch die zu messende Spannung erzeugte Phasendifferenz gerade kompensiert. Damit ist die Größe der zusätzlichen Phasendifferenz ein Maß für die zu messende Spannung, und es kann aus der Größe des Rückstellsignals auf die zu messende Spannung geschlossen werden.

Als nachteilig erweist sich hierbei, daß keine ideale Trennung von Hochspannung und Messelektronik möglich ist, da die Aufspaltung sowie die Zusammenführung der beiden Teilstrahlen vorzugsweise in einem einzigen integriert-optischen (IO)-Chip erfolgt, bei dem konstruktionsbedingt die jeweiligen Elektroden nahe beieinanderliegen. Die zu messende Hochspannung sowie das durch die Messelektronik erzeugte Rückstellsignal können sich somit gegenseitig stören.

Aus US 5,969,341 ist es beispielsweise bekannt, einen Spannungssensor zu verwenden, der eine räumliche Trennung von Messelektronik und Hochspannung ermöglicht. Es werden zwei Licht-Teilstrahlen verwendet, die auf unterschiedlichen, jeweils mittels Reflexion geschlossenen Wegen geführt werden. Die optischen Längen dieser Wege werden durch die zu messende Spannung verändert, wobei jedoch die Geometrie und die Brechungsindesdrift der beiden optischen Wege direkt die Messgenauigkeit beeinflussen und erheblich einschränken.

In DE 41 28 687 A1 ist ein Spannungssensor offenbart, bei dem zur Durchführung der Spannungsmessung ein Zwei-Moden-Laser und 2-Moden-Fasern, die durch einen Piezoring in ihrer optischen Länge beeinflusst werden, verwendet werden. Über die 2-Moden-Faser werden unterschiedlich optische Wege benutzt, deren Konstanz die Messgenauigkeit einschränken.

In DE 44 16 298 A1 ist ein diskretes, optisches Interferometer für Spannungsmessungen beschrieben, das einen elektrooptischen Kristall benutzt. Auch bei diesem Interferometer ist die Messgenauigkeit stark eingeschränkt, da der Mess- und der Referenzstrahl jeweils unterschiedliche optische Wege durchlaufen.

In der Druckschrift US 5,343,036 ist ein faseroptischer Sensor zum Messen von elektrischen Feldern und Spannungen offenbart. Der faseroptische Sensor ist hierbei als doppelmodiges Tandem-Interferometer ausgelegt, das die Längendehnung einer doppelmodigen Phase nutzt, die durch einen piezoelektrischen Körper im elektrischen Feld verursacht werden.

Der Erfindung liegt die Aufgabe zugrunde, ein Verfahren und eine Vorrichtung zur optischen Spannungsmessung bereitzustellen, mit denen sich eine hohe Messgenauigkeit erzielen lässt.

Die Erfindung ist bei einem Verfahren zur elektrooptischen Messung einer Spannung U erfindungsgemäß dadurch gekennzeichnet, dass in einem faseroptischen Sagnac-Interferometer zwei durch Teilung eines von einer Lichtquelle ausgehenden Lichtstrahls erzeugte Teilstrahlen zeitversetzt mittels eines Phasenmodulators moduliert werden, der durch die zu messende Spannung U beaufschlagt wird, wobei die bei Änderung der Spannung U entstehende Phasenverschiebung $\Omega$ beider Teilstrahlen gegeneinander gemessen, und basierend auf einer Spannungsnormaleichung der Phasenverschiebung $\Omega$ aus der gemessenen Phasenverschiebung $\Omega$ die an dem Phasenmodulator anliegende Spannung U errechnet wird.

Eine Vorrichtung zur elektrooptischen Messung einer Spannung U ist erfindungsgemäß gekennzeichnet durch ein faseroptisches Sagnac-Interferometer, bei dem in einen Teil eines Lichtwegs, der Faserstrecken, eine Faserspule, einen ersten Phasenmodulator, einen Polarisator und einen Strahlteiler umfasst, ein zusätzlicher Phasenmodulator, der durch die zu messende Spannung U beaufschlagt wird, so integriert ist, dass an dem Strahlteiler erzeugte, gegenläufige Teilstrahlen bei Änderung der den zusätzlichen Phasenmodulator beaufschlageneden Spannung U zeitversetzt moduliert werden und somit eine Phasenverschiebung $\Omega$ gegeneinander erfahren, und durch eine Auswerteeinheit zur Bestimmung der an dem zusätzlichen Phasenmodulator anliegenden Spannung U aus der ermittelten Phasenverschiebung $\Omega$.

Vorteilhafte Weiterbildungen dieses Erfindungsgedankens sind in abhängigen Patentansprüchen gekennzeichnet.

Die Erfindung und vorteilhafte Einzelheiten werden nachfolgend unter Bezug auf die Zeichnungen in beispielsweiser Ausführungsform näher erläutert. Es zeigen:

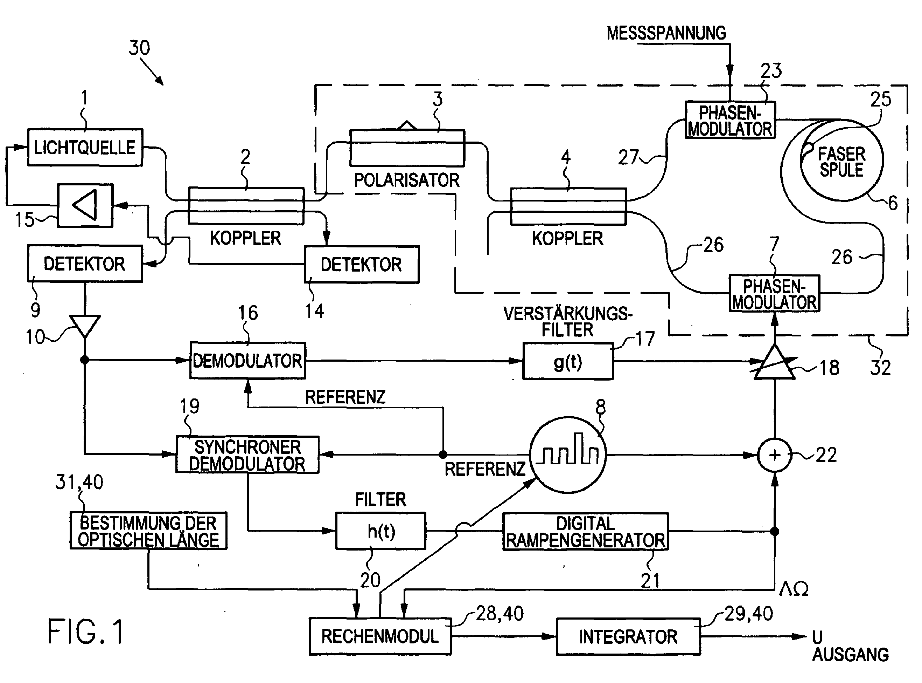

**Fig. 1** das Prinzip-Blockschaltbild eines faseroptischen Sagnac-Interferometers in Closed-Loop-Aufbau mit digitaler Rückstellung, bei dem erfindungsgemäß ein durch die zu messende Spannung beaufschlagter Phasenmodulator in einen durch gegenläufige, von einem Strahlteiler ausgehende Teilstrahlen bestimmten Lichtweg integriert ist;

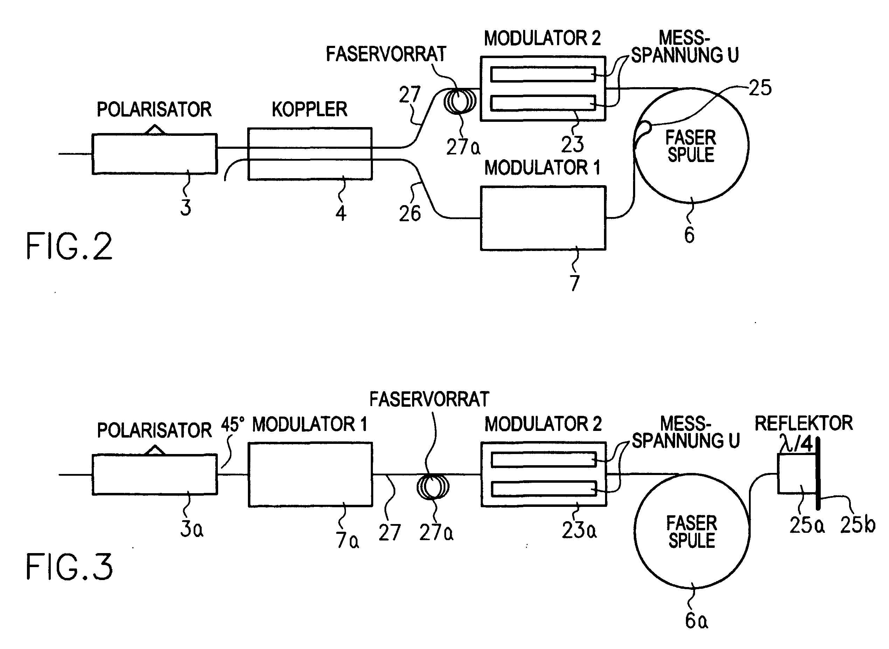

**Fig. 2** eine Prinzipskizze eines über einen Strahlteiler in sich geschlossenen Lichtweges als ein Teil von Fig. 1, in den erfindungsgemäß ein durch die zu messende Spannung U beaufschlagter Phasenmodulator integriert ist, wobei der geschlossene Lichtweg von gegenläufigen Teilstrahlen durchlaufen wird, die von dem Strahlteiler ausgehen;

**Fig. 3** eine Prinzipskizze eines durch Rückreflektion und 90°-Polarisationsdrehung mittels einer $\lambda$/4-Schicht in sich geschlossenen Weges, in den erfindungsgemäß ein durch die zu messende Spannung U beaufschlagter Phasenmodulator integriert ist, wobei der geschlossene Lichtweg durch gegenläufige Teilstrahlen durchlaufen wird, die vom Strahlteiler ausgehen;

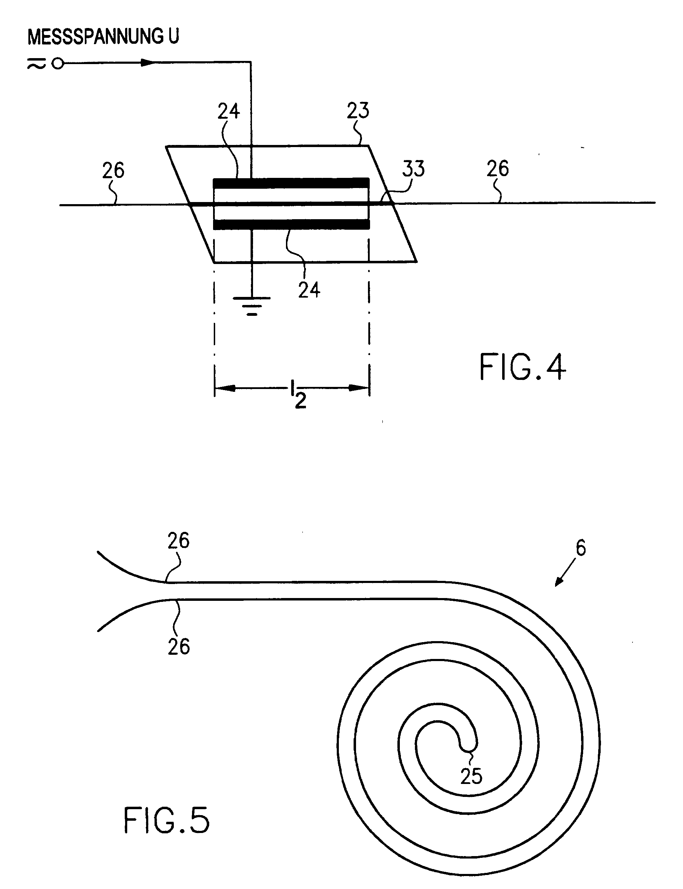

**Fig. 4** eine Prinzipskizze des von der zu messenden Spannung beaufschlagten Phasenmodulators zur Erläuterung des Funktionsprinzips der Erfindung; und

**Fig. 5** eine schematische Darstellung einer drehratenunempfindlichen Spule mit bifilarer Wicklung.

Da Sagnac-Interferometer an sich bekannt sind, soll hier nur kurz unter Bezug auf die Zeichnungen auf deren prinzipielle Funktionsweise eingegangen werden.

Figur 1 veranschaulicht in schematisher Darstellung den typischen bekannten Aufbau eines Sagnac-Interferometers 30 in Closed-Loop-Anordnung. Das Licht einer hinsichtlich Intensität stabilisierten Lichtquelle 1, insbesondere einer Superlumineszenzdiode (SLD) gelangt über eine Faserstrecke auf einen ersten Strahlteiler 2, auch als Koppler bezeichnet, von dort über einen Polarisator 3 auf einen zweiten Strahlteiler, den Hauptstrahlteiler 4. Von den beiden der Lichtquelle 1 abgewandten Aus-/Eingängen gelangen die durch Strahlteilung entstandenen Teilstrahlen auf die beiden Ein-/Ausgänge einer Faserspule 6, wobei zwischen den Aus-/Eingängen des Hauptstrahlteilers 4 bzw. den Ein-/Ausgängen der Faserspule 6 ein erster Phasenmodulator 7 angeordnet ist. Die im Hauptstrahlteiler 4 nach Durchlaufen der Faserspule 6 interferierenden Teilstrahlen durchlaufen wiederum den Polarisator 3 und werden über den ersten Strahlteiler 2 zu einem möglichst halben Anteil auf einen Fotodetektor 9 geleitet. Das Ausgangssignal des Detektors 9 wird zunächst durch einen Verstärker 10 angehoben und beaufschlagt einen Demodulator 16 einerseits und einen Synchrondemodulator 19 andererseits. Der Demodulator 16 bildet zusammen mit einem Verstärkungsfilter 17 eine Skalenfaktorregelstrecke. Der Synchrondemodulator 19 steuert über ein Filter 20 einen Rampengenerator 21 an, der zur Erzeugung eines Rückstellsignals dient. Das durch einen Modulationsoszillator 8 erzeugte Signal zum Verschieben des Arbeitspunktes in den Punkt höchster Empfindlichkeit und das Rückstellsignal werden durch einen Addierer 22 zu einem einzigen Signal zusammengesetzt und bilden das Eingangssignal eines regelbaren Verstärkers 18, welcher dieses Signal mit einem als Verstärkungsfaktor dienenden Ausgangssignal des Verstärkungsfilters 17 verstärkt. Das dadurch erhaltene Ausgangssignal des regelbaren Verstärkers 18 dient wiederum zur Ansteuerung des ersten Phasenmodulators 7, der die optische Phase entsprechend moduliert und rückstellt.

Die erfindungsgemäßen, vom Stand der Technik abweichenden Teile des Interferometers sind mit der Bezugsziffer 32 bzw.40 gekennzeichnet.

Sagnac-Interferometer der oben beschriebenen Art werden in der Regel zur Messung von Drehraten eingesetzt. Dabei wird eine durch Drehung der Spule 6 verursachte Phasenverschiebung, die die gegenläufigen Teilstrahlen aufgrund des Sagnac-Effektes erfahren, ermittelt, und darüber auf die Drehrate beziehungsweise die Größe der Drehung geschlossen.

Erfindungsgemäß werden nun durch geeignete Maßnahmen mögliche Drehungen bzw. Störeffekte ausgeschaltet und stattdessen eine Phasenverschiebung $\Omega$, vorzugsweise über einen zusätzlichen, zweiten Phasenmodulator, mittels einer zu messenden Spannung U gewissermaßen "künstlich" erzeugt. Die Phasenverschiebung $\Omega$ wird beispielsweise durch deren Kompensation über ein Rückstellsignal gemessen.

Bekanntermaßen hängt die Gesamtdurchlaufzeit T der Teilstrahlen durch das Interferometer von einem durch einen Strahlteiler, Faserstrecken, Phasenmodulatoren sowie eine Faserspule definierten Teil (Spulenteil) eines Lichtweges des Interferometers und damit von einer optischer Länge des Lichtweges dieses Teils ab. Dabei sind im die eigentliche Messeinrichtung bildenden Spulenteil der erste Phasenmodulator 7 und der Strahlteiler 4 (zweiter Koppler) sowie der Polarisator 3 typischerweise in einem IO-Chip zusammengefasst. Eine optimale Modulationsfrequenz f des Interferometers hängt wiederum von der Gesamtdurchlaufzeit T der Teilstrahlen durch das Interferometer ab. Da die Faserstrecken zwecks unterschiedlicher Installationen variabel sein sollten und sich außerdem die optische Längen der Faserstrecken mit der Temperatur ändern, wird durch eine Auswerteeinheit des Interferomters in regelmäßigen zeitlichen Abständen die optische Länge des Interferometers bestimmt und die Modulationsfrequenz f danach geregelt. Die optische Länge kann außerdem in das später detailliert beschriebene Verfahren zur Ermittlung der Spannung U zur Korrektur eingebracht werden.

Da es grundsätzlich bekannt ist, die optische Länge eines Interferometers zu messen, soll hier nur beispielhaft auf das Patent US 4,759,629 verwiesen werden, wo ein solches Verfahren sowie die Anpassung der Modulationsfrequenz f an die gemessene optische Länge beschrieben wird.

Im Folgenden wird der mathematische Zusammenhang zwischen der durch die zu messende Spannung U verursachte, am Detektor 9 beobachtbare Phasenverschiebung $\Omega$ und der zu messenden Spannung U anhand des in Figur 1 beziehungsweise 2 gezeigten Ausführungsbeispieles hergeleitet.

Allgemein gilt:

$$\Omega = \frac{2\pi}{\lambda} \, \Delta T \, \frac{dn_2}{dt} \, \ell_2$$

wobei $\lambda$ die Wellenlänge des von der Lichtquelle 1 emittierten Lichts ist. $\Delta T$ ist die differentielle Durchlaufzeit der Teilstrahlen durch den Teil des Interferometers, der in diesem Ausführungsbeispiel durch den Strahlteiler 4, den ersten Phasenmodulator 7, die Faserstrecke 26, sowie die Faserspule 6 minus des Faserweges 27 definiert ist. $\Delta T$ entspricht somit der Zeitversetzung, mit der die Teilstrahlen den zweiten Phasenmodulators 23 durchlaufen. $n_2$ ist der Brechungsindex des die Teilstrahlen führenden Materials 33 innerhalb des zweiten Phasenmodulators 23, $l_2$ die Länge der Elektroden 24 (Fig. 4). Der Term $\Delta T \cdot dn_2/dt$ stellt hierbei eine Näherung für ein Integral in der Zeit über $dn_2/dt$ dar, die für $\Delta T \ll 1/f_0$ gilt, wobei $f_0$ einer Frequenz der zu messenden Spannung U entspricht. Da der Brechungsindex $n_2$ spannungsabhängig ist, läßt sich die obige Formel wie folgt schreiben:

$$\Omega = \frac{2\pi}{\lambda} \, \ell_2 \Delta T \, \frac{dn_2}{dU} \, \frac{dU}{dt} \, , \qquad\qquad (1)$$

wobei $dn_2/dU$ den Skalenfaktor S von Modulatorektroden 24 beschreibt. $dn_2/dU$ ist in der Regel eine Konstante, die im Wesentlichen vom elektrooptischen Verhalten des die Teilstrahlen führenden Materials 33 innerhalb des zweiten Phasenmodulators 23 und dem Abstand zwischen den Modulatorelektroden 24 abhängt. $dU/dt$ ist die zeitliche Ableitung der zu messenden Spannung U.

Aus Formel (1) folgt, dass aus der beobachteten Phasenverschiebung $\Omega$ auf die zeitliche Änderung der zu messenden Spannung $dU/dt$ geschlossen werden kann, wenn die differentielle Durchlaufzeit $\Delta T$ bekannt ist. Diese ist nahezu konstant und läßt sich durch ein Spannungsnormal eichen. Diese wird vorzugsweise bei der Herstellung und/oder Installation des Spannungsmessgeräts durch Anlegen einer Normspannung an die Elektroden 24 des zweiten Phasenmodulators 23 und durch Erfassen der dadurch hervorgerufenen Phasenverschiebung $\Omega$ durchgeführt.

Um den Aufwand dieser Eichung gering zu halten, können die restliche Abhängigkeit der differentiellen Durchlaufzeit $\Delta T$ von der Temperatur durch die Messung der Gesamtdurchlaufzeit T und deren Temperaturabhängigkeit angenähert werden. Es gilt für eine geregelte Modulationsfrequenz f:

$$f = \frac{1}{T} = \frac{C}{n_1\ell_1 + n_2\ell_2} \cong \frac{C}{n_1\ell_1} \qquad\qquad (2)$$

wobei c die Lichtgeschwindigkeit, $l_1$ die Länge des Fasermaterials der Faserstrecken 26 und 27, sowie das der Faserspule 6 und des Kopplers 4 außerhalb der Phasenmodulatoren 23 darstellen. $n_1$ bzeichnet den Brechungsindex des Fasermaterials. Das Produkt $n_2 l_2$ ist als optische Länge der Phasenmodulatoren 7, 23 zu verstehen.

Die Temperaturabhängigkeit von $\Delta T$ und damit von der berechneten Spannung U kann also aufgrund der Modulationsfrequenz f korrigiert werden, da T und $\Delta T$ durch gleiche Materialien beeinflusst werden.

Die Messung der optischen Längen $n_1 l_1$ sowie $n_2 l_2$ erfolgt hierbei vorzugsweise durch ein in die Auswerteeinheit 40 des Interferometers integriertes Messmodul 31.

Ist nach obigen Formeln die zeitliche Ableitung der zu messenden Spannung dU/dt über einen in der Auswerteeinheit 40 enthaltenen Rechenmodul 28 aus den gemessenen Größen $\Delta T$ sowie $\Omega$ bestimmt, so kann auf die Spannung U durch direkte Integration in der Zeit geschlossen werden. Diese Integrationsmethode hat den Vorteil, dass der zeitliche Verlauf der Spannung U auch bei zeitlich variablen Frequenzen der Spannung U wiedergebbar ist.

Liegt die zu messende Spannung U in Form einer Wechselspannung mit fester Frequenz $f_1$ vor, so läßt sich der zeitliche Verlauf der zu messenden Spannung U auch alternativ wie folgt ermitteln:

Für die (Wechsel-)Spannung U gilt allgemein $U = U_0 \sin(\omega t)$. Damit ergibt sich deren zeitliche Ableitung dU/dt, welche aus der Messung der Phasenverschiebung $\Omega$ sowie der Modulationsfrequenz f berechnet wird, zu $dU/dt = U_0 \omega \cos(\omega t)$. Da der zeitliche Verlauf der Wechselspannung U durch Integration der zeitlichen Ableitung dU/dt ermittelt wird, muss somit über eine cos- oder sin-Funktion integriert werden. Für diese gilt:

$$\int \cos(\omega t)dt = \frac{1}{\omega} \sin(\omega t) \quad bzw. \quad \int \sin(\omega t)dt = \frac{1}{-\omega} \cos(\omega t) \qquad (3)$$

Dies gilt unter der Voraussetzung, dass $\omega = 2\pi f_1$ zeitlich konstant ist. Damit lässt sich der Spannungsverlauf U aus der zeitlichen Ableitung dU/dt errechnen, indem die zeitliche Ableitung von U mit dem numerischen Wert $1/\omega$ multipliziert und eine Phasenverschiebung von $\pi/2$ durchgeführt wird. Bei dieser Integrationsmethode muss $f_1$ bekannt sein. Die Frequenz $f_1$ läßt sich jedoch durch Ermittlung der Periodizität von dU/dt, also durch "Nachfahren" von dU/dt, sehr genau bestimmen.

Dieses Integrationsverfahren hat gegenüber dem direkten numerischen Integrationsverfahren den Vorteil einer wesentlich höheren Genauigkeit.

Wenn keine Wechselspannung vorliegt, wird gegebenenfalls ein Spannungs-Offset auf die durch die direkte Integration ermittelte Spannung addiert, da das Verfahren dann nicht zwingenderweise den absoluten Spannungswert U, sondern eventuell einen um eine Konstante verschobenen Spannungswert liefert.

Das erfindungsgemäße Verfahren hat den Vorteil, dass durch den zusätzlichen, zweiten Phasenmodulator 23 eine ideale Trennung von Hochspannung und Messelektronik realisiert werden kann.

Anhand von Figur 3 wird im Folgenden eine alternative Ausführungsform des erfindungsgemäßen Spannungsmeßverfahrens erläutert.

Das von der Lichtquelle 1 über den Koppler 2 erhaltene Licht wird durch einen Polarisator 3a polarisiert und unter 45° gegen die Polarisationsmoden einer vorzugsweise polarisationserhaltenden (PM)-Faser (z. B. Faserpigtail) eingekoppelt, so dass in der gleichen Faser zwei verschiedene Teilstrahlen geführt werden, die gegeneinander um 90° in der Polarisation versetzt sind, also jeweils effektiv einen anderen optischen Lichtweg benutzen. Der erste Teilstrahl durchläuft in einer ersten Polarisation über einen Phasenmodulator 7a, der der optischen Phasenmodulation zur Signalgewinnung und u.U. zur Rückstellung der zu messenden Phasenverschiebung $\Omega$ dient, einen Faservorrat 27a und einen Phasenmodulator 23a für die zu messende Spannung U und eine Faserspule 6a zu einer $\lambda$/4-Schicht 25a mit einem Reflektor 25b (Fig. 3), der das zurückreflektierte Licht um 90° in der Polarisation dreht, und damit in eine zweite Polarisation überführt. Dann läuft der erste Teilstrahl in der zweiten Polarisation wieder den gleichen Weg zurück zu dem Polarisator 3a. Aufgrund der zweiten Polarisation wird der zurücklaufende erste Teilstrahl dabei aber nicht oder zumindest nur geringer moduliert. Dies wird durch Einsatz von Modulatoren 7a, 23a erreicht, die beide Polarisationen leiten, aber vorzugsweise nur eine Polarisation modulieren. Der zweite Teilstrahl durchläuft den Weg bis zum Reflektor 25b in der zweiten Polarisation, und wechselt dann beim Rücklaufen zum Polarisator 3a in die erste Polarisation. Dadurch werden beide Teilstrahlen zu unterschiedlichen Zeiten moduliert, wodurch die Phasenverschiebung $\Omega$ entsteht.

Oben beschriebenes Verfahren hat den Vorteil, dass die beiden Teilstrahlen "gleichzeitig" in derselben Faser verlaufen, wodurch Störquellen durch Phasenverschiebung in Zuleitungen vermieden werden können.

Im Folgenden wird unter Bezugnahme auf die bereits erwähnten Figuren 1, 2, 4 und 5 eine bevorzugte Ausführungsform der erfindungsgemäßen Vorrichtung näher erläutert.

Im bereits beschriebenen, prinzipiellen Aufbau des Sagnac-Interferometers 30 sind durch die Erfindung im Wesentlichen die mit Bezugsziffer 32 bzw. 40 gekennzeichneten Teile betroffen, wobei die mit Bezugsziffer 32 gekennzeichneten Teile den geschlossenen, optischen Weg darstellen. In diesen ist, wie in Figur 1 gezeigt, vorzugsweise an einem Ende der Faserspule 6 in die Faserstrecken 26, 27 ein bereits erwähnter, zweiter, durch die zu messende Spannung U beaufschlagter Phasenmodulator 23 integriert, der beispielsweise ein integrierter optischer Chip (IO-Chip) ist. Der IO-Chip besteht vorzugsweise aus einem Lithiumniobat (LiNbO3)-Kristall, in den, wie in Fig. 4 gezeigt, eine die gegenläufigen Teilstrahlen führende Lichtleitstrecke 33 integriert ist. Diese verläuft teilweise zwischen ebenfalls in den IO-Chip integrierten Elektroden 24, die beispielsweise aus aufgesputtertem Gold bestehen. Weiterhin ist eine Einrichtung 31 zur Ermittlung der Modulationsfrequenz f vorgesehen.

Der zusätzliche Phasenmodulator 23 muß so in den durch den Hauptstrahlteiler 4, den ersten Phasenmodulator 7 sowie die Faserspule 6 definierten Teil des Interferometers integriert sein, daß die am Hauptstrahlteiler 4 erzeugten, gegenläufigen Teilstrahlen diesen zu unterschiedlichen Zeiten durchlaufen, was durch die differentielle Durchlaufzeit ∆T beschrieben wird.

Zur Ermittlung der zu messenden Spannung U aus der Phasenverschiebung $\Omega$ sowie der differentiellen Durchlaufzeit ∆T weist die Vorrichtung 30 Rechenmodule 28, 29 auf. Der Rechenmodul 28 berechnet die zeitliche Ableitung der zu messenden Spannung dU/dt nach der oben beschriebenen Formel (1). Der Rechenmodul 29 ist für die zeitliche Integration der von dem Rechenmodul 28 ermittelten Funktion dU/dt nach einem der oben beschriebenen Integrationsverfahren zuständig.

Um den Einfluss eventueller, insbesondere aufgrund einer eventuellen Drehbewegung des Sagnac-Interferometers 30 verursachter unerwünschter Bewegungen möglichst gering zu halten, ist die Faserspule 6 vorzugsweise so gestaltet, dass sie keine effektive Fläche umspannt, was beispielsweise durch eine bifilare Wicklung der Faserspule 6 erreicht wird. Eine solche Wicklung ist in Fig. 5 gezeigt: Ein Umkehrpunkt 25 der Faserspule 6 ist hierbei so gelegt, dass die Teilstrahlen innerhalb der Faserspule 6 zweimal annähernd denselben geometrischen Weg durchlaufen, wobei die beiden Durchläufe in zueinander entgegengesetzten Richtungen erfolgen. Damit heben sich aufgrund des Sagnac-Effektes bewirkte Phasenverschiebungen auf.

Die Rechenmodule 28, 29 können sowohl auf Hardware-Basis als auch auf Software-Basis realisiert sein.

Der in Fig. 1 beschriebene prinzipielle Aufbau des Sagnac-Interferometers kann in einer weiteren bevorzugten Ausführungsform annähernd unverändert zur Durchführung des oben mittels Fig. 3 beschriebenen Verfahrens verwendet werden, indem lediglich die mit Bezugsziffer 32 bzw. 40 gekennzeichneten Teile des Interferometers aus Fig.1 mit den entsprechenden Teilen aus Fig. 3 ersetzt werden.

Bei dieser Ausführungsform weist der Lichtwegteil 32 des Interferometers 30 den Polarisator 3a aus Fig. 3 auf, mittels dem Licht in zwei Teilstrahlen unterschiedlicher Polarisation aufspaltbar ist. Die Polarisierung des Lichts wird durch eine polarisationserhaltende Faser 27 mit Faservorrat 27a über den Lichtweg hinweg erhalten. Die beiden Modulatoren 7a und 23a sind derart beschaffen, dass sie nur Licht einer bestimmten Polarisation modulieren. Die Faserspule 6a besteht ebenfalls aus polarisationserhaltender Faser. Der Reflektor 25a, 25b entspricht dem Umkehrpunkt 25 einer bifilar gewickelten Spule nach Fig. 5.

Die in Figur 2 und 3 gezeigten Faservorräte 27a dienen dazu, die durch die zu messende Spannung U beaufschlagten Phasenmodulatoren 23, 23a fernab von anderen Bauteilen bzw. von der zugeordneten Elektronik zu installieren.

Der Erfindungsgedanke wurde in Anwendung auf ein faseroptisches Sagnac-Interferometer in Closed-Loop-Aufbau beschrieben. Eine Realisierung ist - für den Fachmann ersichtlich - auch in Open-Loop-Technik möglich, sofern geringere Genauigkeitsanforderungen eine solche prinzipiell kostengünstigere Lösung zulassen.

## Patentansprüche

1. Verfahren zur elektrooptischen Messung einer elektrischen Spannung U, **dadurch gekennzeichnet, dass** in einem faseroptischen Sagnac-Interferometer (30) zwei durch Teilung eines von einer Lichtquelle (1) ausgehenden Lichtstrahls erzeugte Teilstrahlen zeitversetzt mittels eines Phasenmodulators (23) moduliert werden, der durch die zu messende Spannung U beaufschlagt wird, wobei die bei Änderung der Spannung U entstehende Phasenverschiebung $\Omega$ beider Teilstrahlen gegeneinander gemessen und basierend auf einer Spannungsnormaleichung der Phasenverschiebung $\Omega$ aus der gemessenen Phasenverschiebung $\Omega$ die an dem Phasenmodulator (23) anliegende Spannung U errechnet wird.

2. Verfahren nach Anspruch 1, **dadurch gekennzeichnet, dass** das zeitversetzte Modulieren der Teilstrahlen mittels des Phasenmodulators (23) durch zeitversetztes Durchlaufen der Teilstrahlen durch den Phasenmodulator (23) erfolgt.

3. Verfahren nach Anspruch 1, **dadurch gekennzeichnet, dass** das zeitversetzte Modulieren der Teilstrahlen mittels des Phasenmodulators (23) **dadurch** erfolgt, dass die Teilstrahlen so erzeugt werden, dass sie gegeneinander unterschiedliche Polarisationen aufweisen, und dann jeweils zwei Mal einen polarisationsabhängigen Phasenmodulator (23) durchlaufen, wobei vor dem zweiten Durchlauf der Teilstrahlen durch den Phasenmodulator (23) deren Polarisation vertauscht wird.

4. Verfahren nach einem der vorstehenden Ansprüche, **dadurch gekennzeichnet, dass** die Berechnung der Spannung U aus der Phasenverschiebung $\Omega$ **dadurch** erfolgt, dass

- eine zeitliche Ableitung der zu messenden Spannung dU/dt aus der Phasenverschiebung $\Omega$ nach

$$\Omega = \frac{2\pi}{\lambda} \ell_2 \Delta T \frac{dn_2}{dU} \frac{dU}{dt}$$

berechnet wird, wobei $\lambda$ die Wellenlänge der Teilstrahlen, $n_2$ der Brechungsindex des innerhalb des Phasenmodulators (23) die Teilstrahlen führenden Materials. $\ell_2$ die Länge dieses Materials und $\Delta T$ die Zeitdifferenz ist, mit der die Teilstrahlen den Phasenmodulator (23) durchlaufen, und
- eine Integration über dU/dt in der Zeit durchgeführt wird.

5. Verfahren nach Anspruch 4, **dadurch gekennzeichnet, dass** die Integration durch direkte numerische Integration erfolgt.

6. Verfahren nach Anspruch 4, **dadurch gekennzeichnet, dass** die Integration, insofern die Spannung U eine Wechselspannung mit einer Festfrequenz $f_1$ ist, **dadurch** erfolgt, dass die Festfrequenz $f_1$ aus dem zeitlichen Verlauf der zeitlichen Ableitung der Spannung U durch Ermittlung von deren Periodizität ermittelt und dann die zeitliche Ableitung der Spannung U mit einem Faktor von $1/2\pi f_1$ multipliziert wird, und eine sich daraus ergebende Spannungs-Funktion einer Phasenverschiebung von $\pi/2$ unterworfen wird.

7. Verfahren nach einem der vorstehenden Ansprüche, **dadurch gekennzeichnet, dass** die Modulationsfrequenz f aus der optischen Länge des Lichtweges des Interferometers (30) nach

$$f = \frac{1}{T} = \frac{C}{n_1\ell_1 + n_2\,\ell_2} \cong \frac{C}{n_1\ell_1}$$

bestimmt wird, wobei c die Lichtgeschwindigkeit, $l_1$ die Länge eines Fasermaterials (26) außerhalb des Phasenmodulators (23), und $n_1$ dessen Brechungsindex darstellen, sowie die Summe $(n_1l_1 + n_2l_2)$ die optische Länge ist.

8. Verfahren nach Anspruch 7, **dadurch gekennzeichnet, dass** mittels der Modulationsfrequenz f die Temperaturabhängigkeit von der Zeitdifferenz $\Delta T$ korrigiert wird.

9. Verfahren nach einem der vorstehenden Ansprüche, **dadurch gekennzeichnet, dass** die Teilstrahlen durch eine gegen relative Drehbewegungen hinsichtlich einer gegenseitigen Phasenverschiebung der beiden Teilstrahlen unempfindliche Faserspule (6) geführt werden.

10. Vorrichtung zur elektrooptischen Messung einer elektrischen Spannung U, **gekennzeichnet durch** ein faseroptisches Sagnac-Interferometer (30), bei dem in einen Teil (32) eines Lichtwegs, der Faserstrecken (26, 27), eine Faserspule (6), einen ersten Phasenmodulator (7), einen Polarisator (3) und einen Strahlteiler umfasst, ein zusätzlicher Phasenmodulator (23), der **durch** die zu messende Spannung U beaufschlagt wird, so integriert ist, dass an dem Strahlteiler erzeugte, gegenläufige Teilstrahlen bei Änderung der den zusätzlichen Phasenmodulator (23) beaufschlagenden Spannung U zeitversetzt moduliert werden und somit eine Phasenverschiebung $\Omega$ gegeneinander erfahren, und **durch** eine Auswerteeinheit (40) zur Bestimmung der an dem zusätzlichen Phasenmodulator (23) anliegenden Spannung U aus der ermittelten Phasenverschiebung $\Omega$.

11. Vorrichtung nach Anspruch 10, **dadurch gekennzeichnet, dass** die Auswerteeinheit (40) einen ersten Rechenmodul (28) aufweist, mit dem eine zeitliche Ableitung der zu messenden Spannung U aus der Phasenverschiebung $\Omega$ nach

$$\Omega = \frac{2\pi}{\lambda} \ell_2 \Delta T \frac{dn_2}{dU} \frac{dU}{dt}$$

berechenbar ist, wobei $\lambda$ die Wellenlänge der Teilstrahlen, $n_2$ der Brechungsindex des innerhalb des zusätzlichen Phasenmodulators (23) die Teilstrahlen führenden Materials (32), $\ell_2$ die Länge dieses Materials (32), und $\Delta T$ die Zeitdifferenz, mit der die Teilstrahlen den Phasenmodulator (23) durchlaufen, bezeichnen.

12. Vorrichtung nach Anspruch 11, **dadurch gekennzeichnet, dass** die Auswerteeinheit (40) einen zweiten Rechenmodul (29) aufweist, mit dem die zu messende Spannung U durch numerische Integration aus deren zeitlicher Ableitung berechenbar ist.

13. Vorrichtung nach einem der Ansprüche 10 bis 12, **dadurch gekennzeichnet, dass** der zusätzliche Phasenmodulator (23) in einem integriert optischen (IO)-Chip (23) ausgebildet ist.

14. Vorrichtung nach einem der Ansprüche 10 bis 13, **dadurch gekennzeichnet, dass** der zusätzliche Phasenmodulator (23) an einem Ende der Faserspule (6) in den Lichtweg integriert ist.

15. Vorrichtung nach einem der Ansprüche 10 bis 14, **dadurch gekennzeichnet, dass** das Interferometer (30) als Sagnac-Interferometer mit Closed-Loop-Elektronik ausgeführt ist.

16. Vorrichtung nach einem der Ansprüche 10 bis 14, **dadurch gekennzeichnet, dass** das Interferometer (30) als Sagnac-Interferometer mit Open-Loop-Elektronik ausgeführt ist.

17. Vorrichtung nach einem der Ansprüche 10 bis 16, **dadurch gekennzeichnet, dass** die Faserspule (6) so gewickelt ist, dass sie hinsichtlich des Sagnac-Effektes keine effektive Fläche umspannt.

18. Vorrichtung nach Anspruch 17, **dadurch gekennzeichnet, dass** die Faserspule (6) bifilar gewickelt ist.

19. Vorrichtung nach einem der Ansprüche 10 bis 18, **dadurch gekennzeichnet, dass** der Lichtweg des Lichtwegteils (32) durch einen Reflektor (25a, 25b) geschlossen ist, an dem die Teilstrahlen reflektierbar und deren Polarisierung vertauschbar sind.

20. Vorrichtung nach Anspruch 19, **dadurch gekennzeichnet, dass** der Reflektor (25a, 25b) eine $\lambda$/4-Schicht aufweist.

21. Vorrichtung nach Anspruch 19 oder 20, **dadurch gekennzeichnet, dass** die Faserstrecken, die den Polarisator (3a) mit dem Reflektor (25a, 25b) verbinden, aus polarisationserhaltender Faser (27, 27a, 6a) bestehen.

22. Vorrichtung nach einem der Ansprüche 19 bis 21, **dadurch gekennzeichnet, dass** mittels des Polarisators (3a) Licht in verschiedene Polarisationen aufspaltbar ist.

## Claims

1. A method for the electro-optical measurement of an electrical voltage U, **characterised in that**, in a fibreoptic Sagnac interferometer (30), two partial beams produced by the division of one light beam emanating from a light source (1) are modulated at temporally offset intervals by means of a phase modulator (23) which is impinged by the voltage U to be measured, whereby the phase shift $\Omega$ of both partial beams, which results when the voltage U is altered, is measured, one in comparison to the other, and, based on a voltage norm calibration of the phase shift $\Omega$, the voltage U applied at the phase modulator (23) is calculated from the measured phase shift $\Omega$.

2. A method according to claim 1, **characterised in that** the temporally offset modulation of the partial beams by means of the phase modulator (23) is effected by temporally offset pass-through of the partial beams through the phase modulator (23).

3. A method according to claim 1, **characterised in that** the temporally offset modulation of the partial beams by means of the phase modulator (23) is effected by the fact that the partial beams are produced in such a way that, in comparison to each other, they comprise different polarisations, and then in each case twice pass through a polarisation-dependent phase modulator (23), whereby, prior to the second pass-through of the partial beams through the phase modulator (23), their polarisation is exchanged.

4. A method according to one of the preceding claims, **characterised in that** the calculation of the voltage U from the phase shift $\Omega$ is effected by the fact that

- a temporal derivative dU/dt of the voltage to be measured is calculated from the phase shift $\Omega$ in accordance with

$$\Omega = \frac{2\pi}{\lambda} \ell_2 \Delta T \frac{dn_2}{dU} \frac{dU}{dt} \quad ,$$

whereby $\lambda$ is the wavelength of the partial beams, $n_2$ the refractive index of the material conveying the partial beams inside the phase modulator (23), $\ell_2$ the length of said material and $\Delta T$ the time difference by which the partial beams pass through the phase modulator (23), and
- an integration via dU/dt is carried out in time.

**5.** A method according to claim 4, **characterised in that** the integration is effected by means of direct numerical integration.

**6.** A method according to claim 4, **characterised in that** the integration, in as far as the voltage U is an alternating voltage with a fixed frequency $f_1$, is effected by the fact that the fixed frequency $f_1$ is ascertained from the temporal course of the temporal derivative of the voltage U by means of the establishment of its periodicity, and then the temporal derivative of the voltage U is multiplied by a factor of $1 / 2\pi f_1$, and a voltage function resulting from this is subjected to a phase shift of $\pi / 2$.

**7.** A method according to one of the preceding claims, **characterised in that** the modulation frequency f is determined from the optical length of the light path of the interferometer (30) in accordance with

$$f = \frac{1}{T} \approx \frac{c}{n_1 \ell_1 + n_2 \ell_2} \equiv \frac{c}{n_1 \ell_1} \quad ,$$

whereby c represents the light speed, $l_1$ the length of a fibre material (26) outside the phase modulator (23), and $n_1$ its refractive index, and whereby also the sum $(n_1 l_1 + n_2 l_2)$ is the optical length.

**8.** A method according to claim 7, **characterised in that** the temperature dependent response of the time difference $\Delta T$ is corrected by means of the modulation frequency f.

**9.** A method according to one of the preceding claims, **characterised in that** the partial beams are conveyed through a fibre coil (6) that is non-sensitive towards relative rotary movements in respect of a reciprocal phase shift of the two partial beams.

**10.** A device for the electro-optical measurement of an electric voltage U, **characterised by** a fibreoptic Sagnac interferometer (30) in which, integrated into one section (32) of a light path comprising the fibre lengths (26, 27), a fibre coil (6), an initial phase modulator (7), a polariser (3) and a beam divider, there is an additional phase modulator (23) which is impinged by means of the voltage U to be measured and is integrated in such a way that, when the voltage U that is impinging the additional phase modulator (23) is changed, the counter-advancing partial beams produced at the beam divider are modulated at temporally offset intervals and thus undergo a phase shift $\Omega$ against each other, and by an evaluative unit (40) for defining, from the established phase shift $\Omega$, the voltage U being applied at the additional phase modulator (23).

**11.** A device according to claim 10, **characterised in that** the evaluative unit (40) comprises an initial computing module (28) with which a temporal derivative of the voltage U to be measured is calculable from the phase shift $\Omega$ in accordance with

$$\Omega = \frac{2\pi}{\lambda} \ell_2 \Delta T \; \frac{dn_2}{dU} \; \frac{dU}{dt} \; ,$$

whereby $\lambda$ indicates the wavelength of the partial beams, $n_2$ the refractive index of the material (32) conveying the partial beams inside the additional phase modulator (23), $\ell_2$ the length of said material (32) and $\Delta T$ the time difference by which the partial beams pass through the phase modulator (23).

12. A device according to claim 11, **characterised in that** the evaluative unit (40) comprises a second computing module (29) with which the voltage U to be measured is calculable by means of numerical integration from its temporal derivative.

13. A device according to one of the claims 10 to 12, **characterised in that** the additional phase modulator (23) is formed in an integrated optical (IO) chip (23).

14. A device according to one of the claims 10 to 13, **characterised in that** the additional phase modulator (23) is integrated into the light path at one end of the fibre coil (6).

15. A device according to one of the claims 10 to 14, **characterised in that** the interferometer (30) is constructionally formed as a Sagnac interferometer with closed-loop electronics.

16. A device according to one of the claims 10 to 14, **characterised in that** the interferometer (30) is constructionally formed as a Sagnac interferometer with open-loop electronics.

17. A device according to one of the claims 10 to 16, **characterised in that** the fibre coil (6) is wound in such a way that, in respect of the Sagnac effect, it causes no voltage transformation of any effective surface.

18. A device according to claim 17, **characterised in that** the fibre coil (6) has bifilar winding.

19. A device according to one of the claims 10 to 18, **characterised in that** the light path of the light path section (32) is closed by means of a reflector (25a, 25b) on which the partial beams can be reflected and their polarisation exchanged.

20. A device according to claim 19, **characterised in that** the reflector (25a, 25b) comprises a $\lambda/4$ lamination.

21. A device according to claim 19 or 20, **characterised in that** the fibre lengths connecting the polariser (3a) with the reflector (25a, 25b) consist of polarisation-maintaining fibre (27, 27a, 6a).

22. A device according to one of the claims 19 to 21, **characterised in that**, by means of the polariser (3a), light can be split into various polarisations.

## Revendications

1. Procédé de mesure électro-optique d'une tension électrique U, **caractérisé en ce que** dans un interféromètre de Sagnac à fibre optique (30), deux faisceaux partiels produits par la séparation d'un faisceau lumineux provenant d'une source lumineuse (1) sont modulés de manière décalée dans le temps à l'aide d'un modulateur de phase (23) qui est sollicité par la tension à mesurer U, le déphasage $\Omega$ des deux faisceaux partiels qui apparaît lors d'une variation de la tension U étant mesuré et la tension U appliquée au modulateur de phase (23) étant calculée sur la base d'un étalonnage grâce à une normale de tension du déphasage $\Omega$, à partir du déphasage $\Omega$ mesuré.

2. Procédé selon la revendication 1, **caractérisé en ce que** la modulation décalée dans le temps des faisceaux lumineux se fait à l'aide du modulateur de phase (23), grâce à un passage décalé dans le temps des faisceaux lumineux à travers le modulateur de phase (23).

**3.** Procédé selon la revendication 1, **caractérisé en ce que** la modulation décalée dans le temps des faisceaux lumineux se fait à l'aide du modulateur de phase (23) grâce au fait que les faisceaux partiels sont générés de manière à présenter des polarisations différentes et traversent alors deux fois un modulateur de phase dépendant de la polarisation (23), leur polarisation étant changée avant le second passage des faisceaux partiels à travers le modulateur de phase (23).

**4.** Procédé selon l'une des revendications précédentes, **caractérisé en ce que** le calcul de la tension U à partir du déphasage $\Omega$ se fait de telle sorte

- qu'une dérivée dans le temps de la tension à mesurer dU/dt est calculée à partir du déphasage $\Omega$

$$\Omega = \frac{2\Pi}{\lambda} \ell_2 \, \Delta T \, \frac{dn_2}{dU} \, \frac{dU}{dt} \quad ,$$

$\lambda$ désignant la longueur d'onde des faisceaux lumineux, $n_2$ l'indice de réfraction du matériau qui guide les faisceaux lumineux à l'intérieur du modulateur de phase (23), $\ell_2$ la longueur de ce matériau et $\Delta T$ la différence de temps avec laquelle les faisceaux partiels traversent le modulateur de phase (23), et
- qu'une intégration a lieu dans le temps sur dU/dt.

**5.** Procédé selon la revendication 4, **caractérisé en ce que** l'intégration se fait grâce à une intégration numérique directe.

**6.** Procédé selon la revendication 4, **caractérisé en ce que** l'intégration, dans la mesure où la tension U est une tension alternative avec une fréquence fixe $f_1$, se fait de telle sorte que la fréquence fixe $f_1$ est déterminée à partir de la courbe dans le temps de la dérivée dans le temps de la tension U, grâce à la détermination de la périodicité de celle-ci, que la dérivée dans le temps de la tension U est ensuite multipliée par un facteur de $1/2\Pi f_1$ et qu'une fonction de tension qui en résulte est soumise à un déphasage de $\Pi/2$.

**7.** Procédé selon l'une des revendications précédentes, **caractérisé en ce que** la fréquence de modulation f est définie à partir de la longueur optique du trajet optique de l'interféromètre (30) selon

$$f = \frac{1}{T} = \frac{C}{n_1 \ell_1 + n_2 \ell_2} \equiv \frac{C}{n_1 \ell_1},$$

c représentant la vitesse de la lumière, $l_1$ la longueur d'un matériau de fibre (26) à l'extérieur du modulateur de phase (23), et $n_1$ l'indice de réfraction de ce matériau de fibre, et la somme $(n_1 \ell_1 + n_2 \ell_2)$ désignant la longueur optique.

**8.** Procédé selon la revendication 7, **caractérisé en ce que** la dépendance de la différence de temps $\Delta T$ par rapport à la température est corrigée à l'aide de la fréquence de modulation f.

**9.** Procédé selon l'une des revendications précédentes, **caractérisé en ce que** les faisceaux lumineux sont guidés par une bobine de fibre (6) qui est insensible aux rotations relatives, pour ce qui est d'un déphasage mutuel des deux faisceaux partiels.

**10.** Dispositif de mesure électro-optique d'une tension électrique U, **caractérisé par** un interféromètre de Sagnac à fibre optique (30), étant précisé que dans une partie (32) d'un trajet optique qui comprend des liaisons optiques (26, 27), une bobine de fibre (6), un premier modulateur de phase (7), un polarisateur (3) et un séparateur de faisceau, un modulateur de phase supplémentaire (23) sollicité par la tension à mesurer U est intégré de telle sorte que des faisceaux partiels opposés générés au niveau du séparateur de faisceau soient modulés de manière décalée dans le temps lors d'une variation de la tension U sollicitant le modulateur de phase supplémentaire (23) et subissent ainsi un déphasage mutuel $\Omega$, et par une unité d'évaluation (40) pour définir la tension U appliquée au modulateur de phase supplémentaire (23), à partir du déphasage $\Omega$ déterminé.

**11.** Dispositif selon la revendication 10, **caractérisé en ce que** l'unité d'évaluation (40) comporte un premier module de calcul (28) avec lequel une dérivée dans le temps de la tension à mesurer U peut être calculée à partir du déphasage Ω

$$\Omega = \frac{2\Pi}{\lambda} \, \ell_2 \Delta T \, \frac{dn_2}{dU} \, \frac{dU}{dt} \, ,$$

λ désignant la longueur d'onde des faisceaux partiels, $n_2$ l'indice de réfraction du matériau (32) qui guide les faisceaux partiels à l'intérieur du modulateur de phase supplémentaire (23), $\ell_2$ la longueur de ce matériau (32) et $\Delta T$ la différence de temps avec laquelle les faisceaux partiels traversent le modulateur de phase (23).

**12.** Dispositif selon la revendication 11, **caractérisé en ce que** l'unité d'évaluation (40) comporte un second module de calcul (29) grâce auquel la tension à mesurer U peut être calculée par intégration numérique à partir de la dérivée dans le temps de ladite tension.

**13.** Dispositif selon l'une des revendications 10 à 12, **caractérisé en ce que** le modulateur de phase supplémentaire (23) est formé dans une puce optique intégrée (IO) (23).

**14.** Dispositif selon l'une des revendications 10 à 13, **caractérisé en ce que** le modulateur de phase supplémentaire (23) est intégré dans le trajet optique à une extrémité de la bobine de fibre (6).

**15.** Dispositif selon l'une des revendications 10 à 14, **caractérisé en ce que** l'interféromètre (30) est conçu comme un interféromètre de Sagnac avec un système électronique à boucle fermée.

**16.** Dispositif selon l'une des revendications 10 à 14, **caractérisé en ce que** l'interféromètre (30) est conçu comme un interféromètre de Sagnac avec un système électrique à boucle ouverte.

**17.** Dispositif selon l'une des revendications 10 à 16, **caractérisé en ce que** la bobine de fibre (6) est enroulée de telle sorte qu'elle ne couvre pas de surface effective en ce qui concerne l'effet Sagnac.

**18.** Dispositif selon la revendication 17, **caractérisé en ce que** la bobine de fibre (6) est enroulée de manière bifilaire.

**19.** Dispositif selon l'une des revendications 10 à 18, **caractérisé en ce que** le trajet optique de la partie de trajet optique (32) est fermé par un réflecteur (25a, 25b) au niveau duquel les faisceaux lumineux peuvent être réfléchis et leurs polarisations peuvent être changées.

**20.** Dispositif selon la revendication 19, **caractérisé en ce que** le réflecteur (25a, 25b) présente une couche λ/4.

**21.** Dispositif selon la revendication 19 ou 20, **caractérisé en ce que** les liaisons par fibre qui relient le polarisateur (3a) au réflecteur (25a, 25b) se composent d'une fibre à maintien de polarisation (27, 27a, 6a).

**22.** Dispositif selon l'une des revendications 19 à 21, **caractérisé en ce que** la lumière peut être divisée en polarisations différentes à l'aide du polarisateur (3a).

FIG.1

EP 1 186 896 B1

FIG.2

POLARISATOR
3

KOPPLER
4

FASERVORRAT
27
27a

MODULATOR 2
23
MESS-SPANNUNG U
25

MODULATOR 1
7

FASER SPULE
6

26

FIG.3

POLARISATOR 45°
3a

MODULATOR 1
7a

FASERVORRAT
27
27a

MODULATOR 2
23a
MESS-SPANNUNG U

FASER SPULE
6a

REFLEKTOR
λ/4
25a
25b

MESSSPANNUNG U

FIG.4

FIG.5